# EUROPÄISCHE PATENTSCHRIFT

(11) **EP 2 415 332 B1**
(45) Veröffentlichungstag und Bekanntmachung des Hinweises auf die Patenterteilung: **30.07.2014**
(21) Anmeldenummer: 10803568.4
(22) Anmeldetag: 17.12.2010
(51) Int. Cl.: H05K 1/18, H05K 3/46, H05K 3/42, H05K 3/20, H01L 21/683, H01L 23/00, H01L 23/538, H01L 21/56, H01L 21/48, H01L 23/31

(54) **LEITERSTRUKTURELEMENT UND VERFAHREN ZUM HERSTELLEN EINES LEITERSTRUKTURELEMENTS**
CONDUCTOR STRUCTURAL ELEMENT AND METHOD FOR PRODUCING A CONDUCTOR STRUCTURAL ELEMENT
ÉLÉMENT À STRUCTURE CONDUCTRICE ET PROCÉDÉ DE FABRICATION DUDIT ÉLÉMENT

(30) Priorität: 18.12.2009 DE 102009060480
(43) Veröffentlichungstag der Anmeldung: 08.02.2012
(73) Patentinhaber: Schweizer Electronic AG, 78713 Schramberg (DE)
(72) Erfinder: GOTTWALD, Thomas, 78655 Dunningen-Seedorf (DE); NEUMANN, Alexander, 78628 Rottweil (DE)
(74) Vertreter: Hössle, Markus
(86) Internationale Anmeldenummer: PCT/EP2010/007736
(87) Internationale Veröffentlichungsnummer: WO 2011/079918

(56) Entgegenhaltungen:
- GB-A- 1 005 943
- JP-A- 2007 276 319
- US-A- 2 692 190
- US-A1- 2002 039 808

## Beschreibung

Die vorliegende Erfindung betrifft ein Leiterstrukturelement sowie ein Verfahren zum Herstellen eines Leiterstrukturelements.

Aus der DE 2 242 132 B2 ist ein Verfahren zur Herstellung einer durchkontaktierten Leiterplatte bekannt, bei dem eine dünne Kupferschicht einer Dicke von weniger als 17 µm galvanisch auf einem provisorischen Träger aus Aluminium in einer Dicke von weniger als 200 µm abgeschieden wird. Die auf der Kupferschicht wird anschließend eine endgültige Isolierplatte aus glaserverstärkten Epoxidharz aufgebracht und der Mehrschichtaufbau wird laminiert oder gepresst, worauf der provisorische Träger bzw. Hilfsträger aus Aluminium beispielsweise durch abstreifen oder ätzen entfernt wird. Anschließend wird auf dem auf diese Weise erhaltenen Produkt ein Ätzresist aufgebracht, dass einem gewünschten Schaltbild entspricht und die unbedeckten Teile der dünnen Kupferschicht werden durch ätzen entfernt. Nach Auflösung des Ätzresist wird die endgültige gedruckte Schaltung erhalten.

Aus der DE 10 2005 032489 B3 ist ein Leiterplatten-Mehrschichtaufbau mit einem Schichtstapel aus mehreren elektrisch isolierenden und/oder leitenden Schichten und wenigstens einem passiven oder aktiven elektrischen Bauteil im Innern des Schichtstapels bekannt, wobei ein Insert Stück im Inneren des Schichtstapels vorgesehen ist, das sich lateral nur in einem Teilbereich der Flächenausdehnung des Schichtstapels erstreckt und eine Umverdrahtungsträgerschicht aufweist, auf der das elektrische Bauteil angebracht ist.

Aus der US 2002/0039808 A1 ist eine Halbleiteranordnung bekannt, zu deren Erzeugung auf einer Kupferfolie eine Leiterstruktur mit darauf aufgesetztem Chip aufgebracht wird. Diese Anordnung wird dann mit einem Epoxidharz laminiert. Nach dem Laminieren wird die Kupferfolie entfernt, so dass die in die Harzschicht eingebettete Leiterstruktur aus Nickel bündig abschließend freigelegt wird. Zur Ausbildung von Kontaktierstellen auf der Leiterstruktur wird auf dieser ein Polyimidfilm mit Öffnungen aufgebracht, die mit Lötkugeln gefüllt werden.

Ausgehend hiervon wird erfindungsgemäß ein Verfahren zum Herstellen eines Leiterstrukturelements mit den Merkmalen des Anspruchs 1 sowie ein Leiterstrukturelement mit den Merkmalen des Anspruchs 12 vorgeschlagen.

Die Erfindung basiert auf dem Grundgedanken, bei der Herstellung möglichst dünner Leiterstrukturelemente (bei denen es sich beispielsweise auch um einen sog. Interposer handeln kann, wie er aus der eingangs zitierten DE 10 2005 032489 B3 bekannt ist) einen starren Träger zu verwenden, auf dem galvanisch eine Kupferbeschichtung haftfest abgeschieden wird, auf der wiederum eine Leiterbildstruktur gefolgt von einer eventuellen Bauelementbestückung aufgebracht wird. Das so (hergestellte Zwischenprodukt wird mit mindestens einer elektrisch isolierenden Lage isoliert und anschließend wird der starre Träger abgelöst und die galvanisch abgeschiedene Kupferbeschichtung des Trägers wird entfernt, so dass eine Freilegung (elektrische Trennung) der Leiterbildstruktur erfolgt.

Unter dem Begriff "Leiterstrukturelement" ist im Rahmen der vorliegenden Erfindung jede Art von zwei- oder mehrschichtigem Aufbau mit mindestens einer Ebene einer Leiterbildstruktur zu verstehen. Dies umfasst bestückte oder nicht bestückte Leiterplatten bzw. Leiterplattenteile, Multilayerstrukturen, Interposer zur Verwendung als "Bauteilgehäuse" in vorgefertigten Mehrschicht-Leiterplattenstrukturen, usw.

Das erfindungsgemäße Vorgehen ermöglicht die Herstellung äußerst dünner und sehr feiner Leiterbildstrukturelemente und Mehrschichtstrukturen, da der Herstellungsprozess einschließlich Schritten wie Löten, Bestücken, Ätzen, Durchkontaktieren usw. auf einer fest mit dem starren Träger verbundenen Kupferschicht erfolgt und somit ohne große Schwierigkeiten durchführbar ist.

Bei dem Ablösen des starren Trägers kann es sich beispielsweise um chemisches oder physikalisches oder mechanisches Ablösen bzw. Entfernen handeln. Beispielsweise besteht der starre Träger aus einem amphoteren Material bzw. Metall, das in einer basischen Lösung, die Kupfer nicht angreift, aufgelöst werden kann. So kann beispielsweise Aluminium oder eine Aluminiumlegierung als Material für den starren Träger verwendet werden, und das Ablösen kann durch Abätzen des starren Trägers in einer Natronlauge erfolgen, ohne dass die galvanische Kupferbeschichtung des Trägers angegriffen wird. Andere amphotere Materialien bzw. Metalle können ebenso verwendet werden; diese sind dem Fachmann bekannt (wie beispielsweise Zink). Eine weitere Möglichkeit besteht beispielsweise in der Verwendung von mechanisch entfernbaren Trägern, wie z.B. durch Fräsen.

Der Begriff "starrer Träger" vermittelt dem Fachmann die Lehre, ein ausreichend dickes Trägermaterial zu verwenden, um sicherzustellen, dass während der Herstellung der Leiterbildstruktur und der anschließenden weiteren Be- und Verarbeitung einschließlich der Bauelementbestückung keine unerwünschten Biegungen des Schichtaufbaus auftreten. Bei der Verwendung eines starren Trägers aus Aluminium kann dies beispielsweise durch Schichtdicken von ca. 500 µm bis 1.000 µm erzielt werden; selbstverständlich können auch dickere Schichten verwendet werden, was jedoch unter Umständen ökonomisch wenig sinnvoll ist. Auch die Verwendung von etwas dünneren Schichten, womöglich bis ca. 350 bis 400 µm Schichtdicke, ist denkbar, wobei bei derartigen Schichtdicken bereits das Risiko einer leichten Biegung während der Verarbeitung eintritt. Die Dicke wird dabei jeweils an die zu verwendende Formatgröße angepasst. Bei der Wahl anderer Materialien können die Schichtdicken entsprechend variieren.

Die galvanische Kupferbeschichtung des starren Trägers weist typischerweise eine Dicke zwischen ca. 2 und ca. 7 µm auf. Vor dem Aufbringen der galvanischen Kupferbeschichtung ist ggf. eine dem Fachmann geläufige Vorbehandlung des starren Trägers notwendig (im Falle der Verwendung von Aluminium bspw. eine übliche Zinkat-Behandlung). Durch die Verkupferung des starren Trägers, die entweder vollständig oder zumindest auf der zum Aufbringen einer Leiterbildstruktur vorgesehenen Oberfläche des starren Trägers erfolgt, entsteht eine plattierbare Oberfläche, die zudem mit den üblicherweise verwendeten Prozesschemikalien kompatibel ist.

Das Aufbringen der Leiterbildstruktur erfolgt nach den dem Fachmann bekannten üblichen Verfahren, wie beispielsweise dem Pattern-Plating-Verfahren (Leiterbahnenaufbau). Die Aufplattierung umfasst ggf. auch das Aufbringen von sog. Passermarken. Alternativ zu den Passermarken können auch Löcher zur späteren Ausrichtung bei der Bestückung vorgesehen werden.

Unter der plattierten Leiterbildschicht kann optional noch eine ätzbeständige Metalllage abgeschieden werden.

Die plattierte Schicht kann an den Bauelementkontakten eine Beschichtung wie beispielsweise eine Edelmetallbeschichtung erhalten.

Anschließend an die erste Plattierung (also die erste Leiterbildstruktur) können mit weiteren geeigneten Prozessschritten (wie beispielsweise Fotoprozessen) einzelne Bereiche gezielt stärker aufplattiert werden als andere, so dass unterschiedliche Kupferschichtdicken in einer Lage erzeugt werden. Dieses Vorgehen unterscheidet sich vom Stand der Technik, der lehrt, eine dicke Kupferschicht vorzusehen und diese partiell ätztechnisch abzudünnen.

Vor der Bauelementbestückung kann eine Vereinzelung des starren und großflächigen Trägers, der im sogenannten Fertigungsformat vorliegt, in kleinere Formatgrößen (Einzelkarten-Größe) erfolgen. Das sogenannte Einzelkartenformat ist ein Format, das in Standard-Bestückungsgeräten handhabbar ist. Dies erleichtert die Bauelementbestückung im Rahmen eines Standard-Prozesses und wird erfindungsgemäß dadurch ermöglicht, dass der starre Träger für ein starres und ebenes Substrat sorgt und mögliche Biegungen des Substrats während der Verarbeitung so weit minimiert sind, dass sie keinen negativen Einfluss auf das Bestückungsergebnis haben. Typische Bauelemente zur Bestückung umfassen u.a. (ungehäuste) Silicium-Chips, passive Komponenten (C, R, L, d.h. Kondensatoren, Widerstände, Spulen oder Induktivitäten) aber auch beispielsweise Inlays bzw. Insertstücke (vgl. die bereits zitierte DE 10 2005 032 489 B3).

Weitere Aufbau- und/oder Verbindungstechnologien, die im Rahmen der weiteren Be- bzw. Verarbeitung des Leiterplatten-Mehrschichtaufbaus Anwendung finden, sind beispielsweise Flip-Chip-Löten, das Aufbringen von Au-Stud-Bumps, ACA/ICA-Kleben usw.

Nach der Bestückung kann optional ein sogenannter Underfilling-Prozess, also das Unterfüllen mindestens eines der bestückten Bauelemente, stattfinden. Bei vielen Anwendungen dürfte jedoch das Harz der noch Verwendung findenden Prepreg-Schichten ausreichen, um den Bereich unter dem Bauelementen bzw. Chips zu verfüllen.

Nach erfolgter Bestückung können die Einzelkarten in einen geeigneten Rahmen (Verlegerahmen) zur parallelen Weiterverarbeitung eingesetzt werden.

Die bestückten Mehrschichtaufbauten werden dann mit einer Prepreg-Schicht versehen. Dabei kann es sich entweder um eine vollflächige Schicht oder um eine Schicht mit im Bereich der bestückten Bauteile angeordneten Ausnehmungen oder eine Kombination von beidem handeln. Dieser Schichtaufbau wird zusammen mit einer Abschlusslage, die beispielsweise aus einer Kupferfolie gebildet ist, und/oder mit einem aus einer Abfolge mehrerer leitender und isolierender Lagen bestehenden Leiterplatten-Halberzeugnis verpresst, wodurch die Bauelemente einlaminiert werden. Die Abschlusslagenfolie kann eine Dicke von ca. 5 µm bis ca. 105 µm aufweisen, in Ausnahmefällen kann sie auch noch dicker sein. Dünnen Folien, z.B. 5 oder 7µm dicke Folien, werden sehr häufig mit einer dickeren, ablösbaren Trägerfolie verlegt. Bei der Verwendung einer solchen dünnen Kupferfolie kann die Trägerfolie nach dem Verpressen leicht abgezogen werden, da durch den starren Träger das Gesamtlaminat ebenfalls starr ist und eine ausreichende Steifigkeit aufweist, die den beim Abziehen auftretenden Kräften widersteht.

Nach dem Einlaminieren liegt ein starres Substrat vor, das mittels weiteren, an sich bekannter Leiterplattenprozesse problemlos weiterverarbeitbar ist. So können, falls dies erforderlich ist, beispielsweise Sacklöcher zu einem bestückten Chip oder zu der Unterseite anhand bekannter Techniken, beispielsweise mittels Laser, gebohrt werden. Ist eine exakte Positionierung der Laserlöcher zu den Bauteilen erforderlich, so kann in diesem Verfahrensabschnitt auf die aufplattierten Passermarken bzw. angebrachten Löcher zurückgegriffen werden.

Nach der Strukturierung der plattierten Lagen erfolgt schließlich das bereits beschriebene erfindungsgemäße Ablösen des starren Trägers. Wie bereits beschrieben, kann es sich dabei beispielsweise um einen alkalischen Ätzprozess handeln, durch den die Kupferbeschichtung nicht bzw. nicht wesentlich angegriffen wird. Dabei kann es sich um reine Natronlauge (NaOH) handeln. Nach dem erfindungsgemäßen Ablösen des starren Trägers bleibt die auf dem starren Träger ursprünglich galvanisch abgeschiedene Kupferbeschichtung zurück, die im Vergleich zu der aufplattierten Umverdrahtungsstruktur sehr dünn ist und beispielsweise auch ohne dazwischenliegenden Ätzresist sehr einfach differenzgeätzt werden kann, wodurch die eingebettete Leiterbildstruktur freigelegt und somit von der galvanischen Kupferschicht elektrisch getrennt wird.

Nach dem beschriebenen Schritt des Verpressens kann direkt geätzt (zum Ablösen des starren Trägers) und ggf. differenzgeätzt werden. Zur Erzielung erhöhter Kontaktflächen können die dazu vorgesehenen Stellen während des Ätzprozesses durch eine entsprechende Beschichtung (Fotoresist) geschützt werden.

Die freigelegten Leiterbahnen können teilweise oder vollständig mit Lötstopplack geschützt werden oder mit einer weiteren Prepreg-Lage verpresst werden, wodurch die Beständigkeit des Leiterplatten-Mehrschichtaufbaus hinsichtlich Temperaturzyklen erhöht wird.

Mit der Erfindung lassen sich ultradünne Bauteil-Packages erzielen, die beispielsweise auch als Interposer für die weitere Einbettung in Leiterplatten einsetzbar sind. Eine weitere Anwendung kann die Herstellung von ultradünnen flexiblen Schaltungsträgern mit bereits bestückten Komponenten zum Aufsetzen auf sogenannten Flex-Substraten sein.

Schließlich eröffnet die Erfindung im Hinblick auf die Herstellung ultradünner Packages die Möglichkeit, einen bestückten Chip mechanisch und/oder chemisch abzutragen, indem das "tote" Silicium des Chips, d.h., die nicht-aktiven Chiplagen, bis auf die aktiven Chip-Lagen entfernt wird. Dazu kann eine ätzresistente Schicht aufgebracht werden, die eine ausreichende Dicke aufweist, um die aktiven Chiplagen seitlich zu bedecken. Die nach oben überstehenden nicht-aktiven Chiplagen werden dann entfernt, bspw. durch chemisches Ätzen. Auch ein mechanisches Entfernen der nicht-aktiven Siliziumschicht ist möglich.

Weitere Vorteile und Ausgestaltungen der Erfindung ergeben sich aus der Beschreibung und der beiliegenden Zeichnung.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand eines Ausführungsbeispieles in der Zeichnung schematisch dargestellt und wird im Folgenden unter Bezugnahme auf die Zeichnung ausführlich beschrieben.
Figur 1 zeigt zur Veranschaulichung des erfindungsgemäßen Verfahrens einen starren Träger mit Kupferbeschichtung in seitlicher Schnittdarstellung.

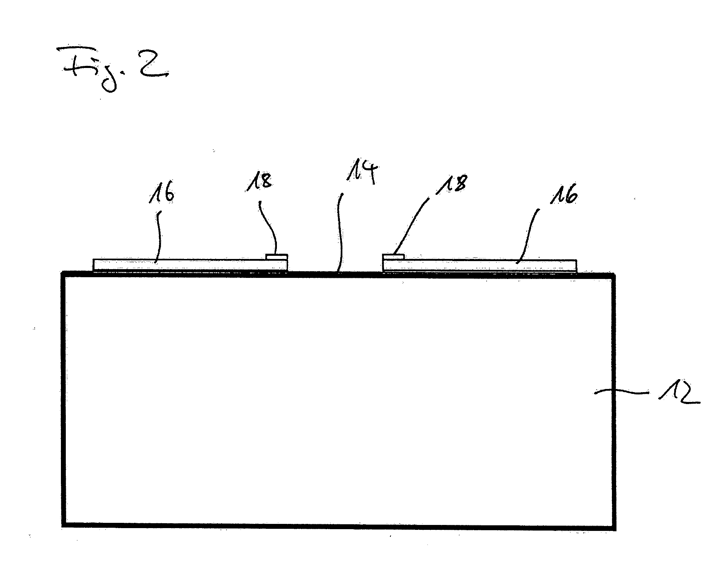

Figur 2 zeigt den Träger der Figur 1 mit einer aufgebrachten Leiterbildstruktur.

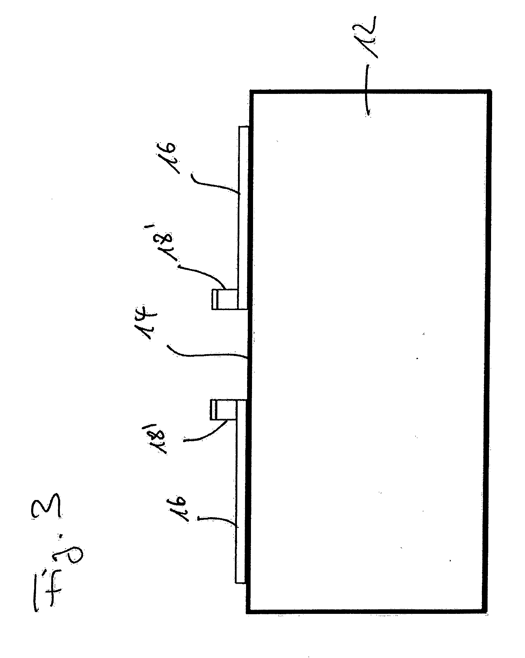

Figur 3 zeigt den Trägeraufbau der Figur 2 mit erhöhten Kontaktierungen.

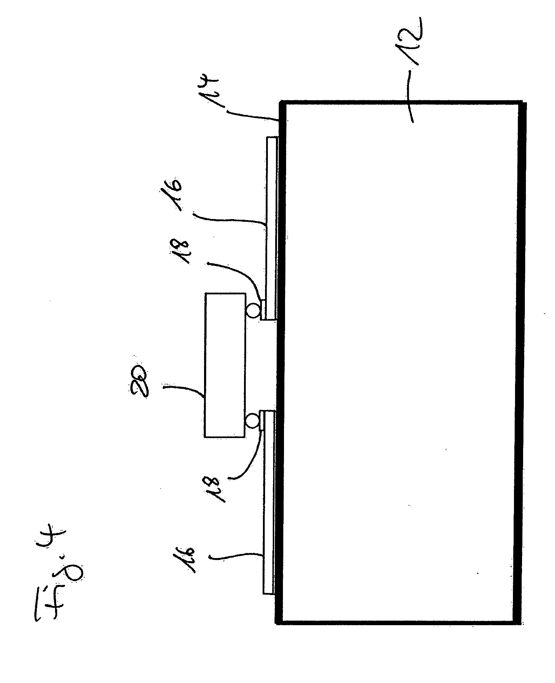

Figur 4 zeigt den Trägeraufbau der Figur 2 nach einer Bauelementbestückung.
Figur 5 zeigt den Trägeraufbau der Figur 4 mit einem unterfüllten Bauelement.
Figur 6 zeigt in Draufsicht in stark schematischer Darstellung einen Verlegerahmen mit eingesetzten und bestückten Einzelkarten.
Figur 7 zeigt den Trägeraufbau der Figur 5 vor dem Verpressen.
Figur 8 zeigt den Trägeraufbau der Figur 7 nach dem Verpressen.
Figur 9 zeigt den Trägeraufbau der Figur 8 nach dem Abziehen der auflaminierten Trägerfolie.
Figur 10 zeigt den Trägeraufbau der Figur 9 mit Durchkontaktierungen.
Figur 11 zeigt das erfindungsgemäße Leiterstrukturelement nach dem Entfernen des starren Trägers.
Figur 12 zeigt einen alternativen Mehrschichtaufbau zu der Darstellung der Figur 11.
Figur 13 zeigt weitere alternative Mehrschichtaufbauten.
Figur 14 zeigt ein Ausführungsbeispiel für ein erfindungsgemäßes Leiterstrukturelement mit durch Lötstopplack geschützten Leitern.
Figur 15 zeigt ein weiteres Ausführungsbeispiel eines erfindungsgemäßen Leiterstrukturelements, das als "Bauteilgehäuse" in eine Multilayerstruktur eingebettet ist.
Figur 16 zeigt ein weiteres Ausführungsbeispiel eines erfindungsgemäßen Leiterstrukturelements.
Figur 17 zeigt ein erfindungsgemäßes ultradünnes Package auf einem Flex-Substrat in seitlicher Schnittdarstellung.
Figuren 18 und 18a zeigen in seitlicher Schnittdarstellung ein erfindungsgemäßes Leiterstrukturelement, bei dem aktive Chiplagen seitlich mit einem permanenten Ätzresist abgedeckt sind.
Figur 19 zeigt das Leiterstrukturelement der Figur 18 mit einem rückgedünnten Chip, d.h. einem Chip mit entfernten nicht-aktiven Lagen.
Figur 19a zeigt in alternativer Ausführungsform zu der Figur 19 das Leiterstrukturelement der Figur 18a mit nach der Rückdünnung tieferliegendem Chip.
Figur 20 zeigt das Leiterstrukturelement der Figur 19 nach dem Verpressen.
Figur 20a zeigt das Leiterstrukturelement der Figur 19a nach dem Verpressen.
Figur 21 zeigt das Leiterstrukturelement der Figur 20 nach dem Ablösen des starren Trägers und Differenzätzen.

Das erfindungsgemäße Verfahren wird nun unter Bezugnahme auf die Figuren beschrieben. Es ist darauf hinzuweisen, dass die Darstellungen in den Figuren stark schematisch und insbesondere nicht maßstabsgetreu sind.

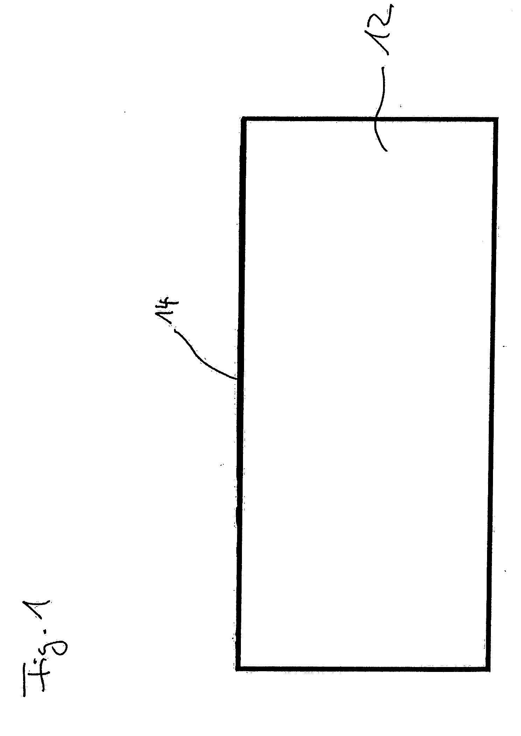

Figur 1 zeigt in seitlicher Schnittdarstellung einen starren Träger 12, der im wesentlichen quaderförmige Form hat und insbesondere mindestens eine ebene Oberfläche aufweist. Der starre Träger 12 dient erfindungsgemäß als Basis zum Aufbringen eines Mehrschichtaufbaus. Bei dem starren Träger handelt es sich um ein wie bereits eingangs beschrieben ausreichend starres Material, um bei der weiteren Bearbeitung der auf dem Träger aufzubringenden dünnen Schichten schädliche Biegungen des Schichtaufbaus weitestgehend zu verhindern.

Des weiteren muss der starre Träger gemäß der Erfindung die Materialeigenschaft aufweisen, ohne Beschädigung der darauf aufgebrachten Kupferschichten lösbar zu sein. Bspw. handelt es sich bei dem starren Träger um Träger aus amphoterem Metall wie bspw. Aluminium oder eine geeignete Aluminiumlegierung.

Auf dem Träger wird galvanisch eine Kupferbeschichtung 14 abgeschieden. Ggf. erfordert dies eine Vorbehandlung des starren Trägers, wie im Falle von Aluminium z.B. eine übliche Zinkatbehandlung.

In einem nächsten Schritt erfolgt auf der galvanisch abgeschiedenen Kupferbeschichtung 14 ein Leiterbildprozess, d.h. es wird eine Leiterbildstruktur 16 fotolithographisch aufgebracht, bspw. im sogenannten Pattern-Plating-Prozess. Auf der Leiterbildstruktur 16 werden ggf. durch selektives Plattieren Kontaktflächen 18 für Bauelemente ausgebildet, die u.U. mit einer Edelmetallbeschichtung (Au, Ag, NiPdAu, usw.) versehen werden.

Zwischen der Kupferbeschichtung 14 und der Leiterbildstruktur 16 kann noch eine (nicht dargestellte) ätzbeständige Sperrschicht, bspw. aus Au, Ag, Ni, usw., vorgesehen sein.

Die Kontaktflächen für Bauelemente können alternativ als Säulen 18` mit oder ohne Bauelementkontakte ausgebildet sein. Durch den höheren Abstand zur Leiterbildstruktur wird die Zuverlässigkeit der Verbindung zwischen Bauelement und Leiterstruktur im späteren Einsatz erhöht, verbunden mit einer Vereinfachung der Wafer-Präparation. Üblicherweise ist die Ausbildung von derartigen Säulenstrukturen auf dünnen Schichten äußerst problematisch - mit der Erfindung ist es möglich, auch dünnste Schichten mit derartigen Kontakthöckern für Bauelemente zu versehen.

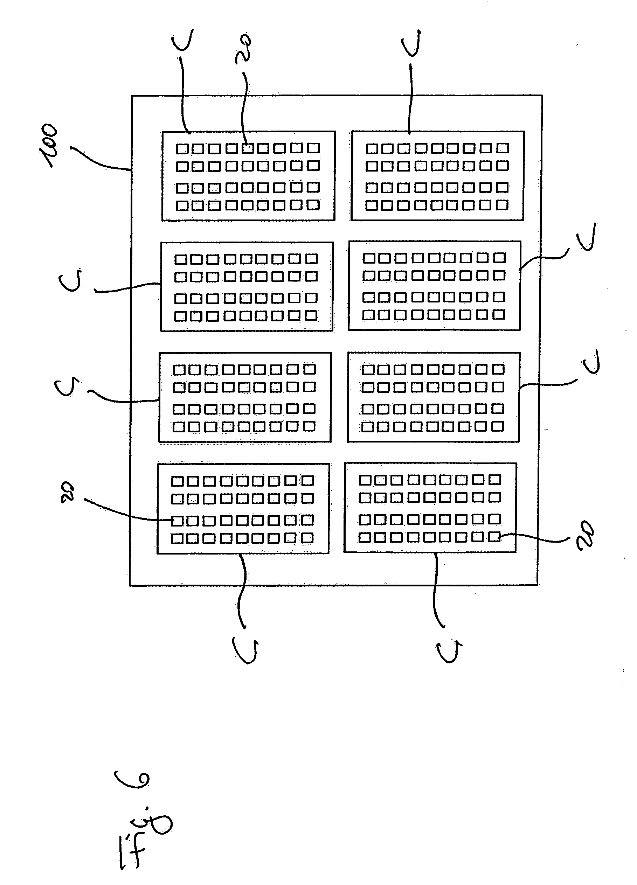

In einem nächsten Schritt erfolgt das Bestücken der Leiterbildstruktur mit Bauelementen 20, bspw. einem Chip oder anderen üblichen aktiven und/oder passiven Bauelementen. Auch die Bestückung gestaltet sich erfindungsgemäß auf der dünnen Leiterbildschicht sehr einfach, da durch den starren Träger 12 eine starre und ebene zu bestückende Oberfläche vorliegt. Vor dem Bestückungsvorgang kann der in einem größeren Format vorliegende starre Träger 12 "vereinzelt" werden, d.h. in seinem Format auf Einzelkartenformate, z.B. auf die sogenannte "Europakarte", zerteilt werden, die dann nach dem Bestücken zur weiteren (parallelen) Verarbeitung wieder in einen Verlegerahmen zurückverlegt werden können. Figur 6 zeigt beispielhaft in schematischer Draufsicht einen Verlegerahmen 100 mit eingelegten und mit Bauelementen 20 bestückten Einzelkarten C.

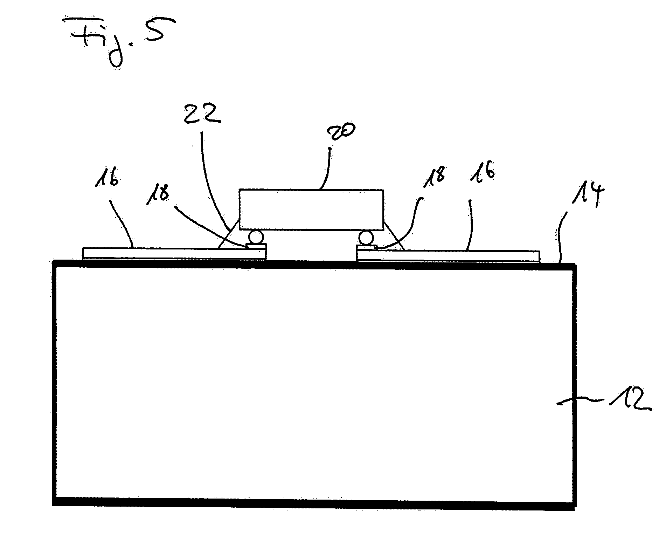

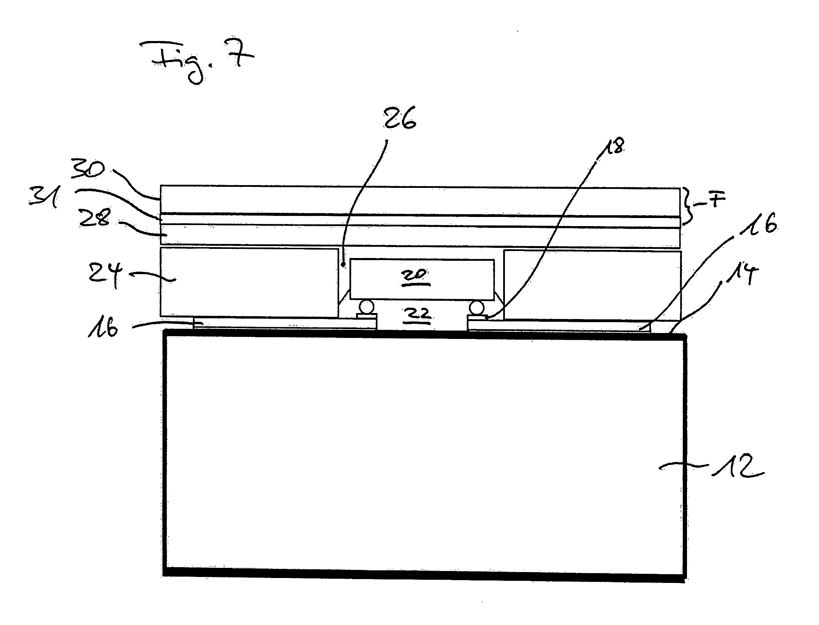

Die bestückten Bauelemente können alle oder zum Teil mit einem geeigneten Material in an sich bekannter Art und Weise unterfüllt werden (Figur 5, Bezugszeichen 22) bevor (ebenfalls in an sich bekannter Art und Weise) Verpresslagen, wie Klebelagen oder Prepreg-Lagen o.a., zum Verpressen des Mehrschichtaufbaus aufgelegt werden, wie dies in Figur 7 schematisch dargestellt ist. Je nach Bestückung der Leiterbildstruktur 16 kann ein vollflächiges Prepreg aufgelegt werden oder - wie in der Darstellung der Figur 7 - eine erste Prepreg-Schicht 24 mit einer Ausnehmung 26 zur Aufnahme eines Bauelements 20, und darauf eine zweite, vollflächige Prepreg-Schicht 28. Durch dieses Vorgehen wird um das Bauelement 20 eine Kavität erzeugt. Alternativ kann eine Prepreg-Schicht mit einer nichtdurchgehenden Ausnehmung verwendet werden, die bereits eine Kavität bildet. Auf die vollflächige Prepregschicht 28 kann in Abhängigkeit von der Bauteilegeometrie auch verzichtet werden. Auf der oberen Prepreg-Schicht 28 bzw. 24 kann noch eine Kupferfolie F aufgebracht werden, bevor die gesamte Struktur - abermals in an sich bekannter Art und Weise - verpresst wird. Anstelle von Prepreg-Schichten kann auch harzbeschichtete Kupferfolie, sog. RCC- Folie (Resin Coated Copper) oder RCF (Resin coated Foil) verwendet werden. In diesem Fall kann auf die Ausbildung von Kavitäten in Abhängigkeit von der Bauteilgeometrie verzichtet werden. Um auf die Verwendung von Kavitäten bzw. Durchbrüchen bzw. Ausnehmungen (26) in Prepregs verzichten zu können, ist es ebenfalls denkbar, durch eine Flüssigbeschichtung der Zwischenräume ein ebenes Substrat zu erhalten, auf dem mit weiteren Prepregs aufgebaut werden kann.

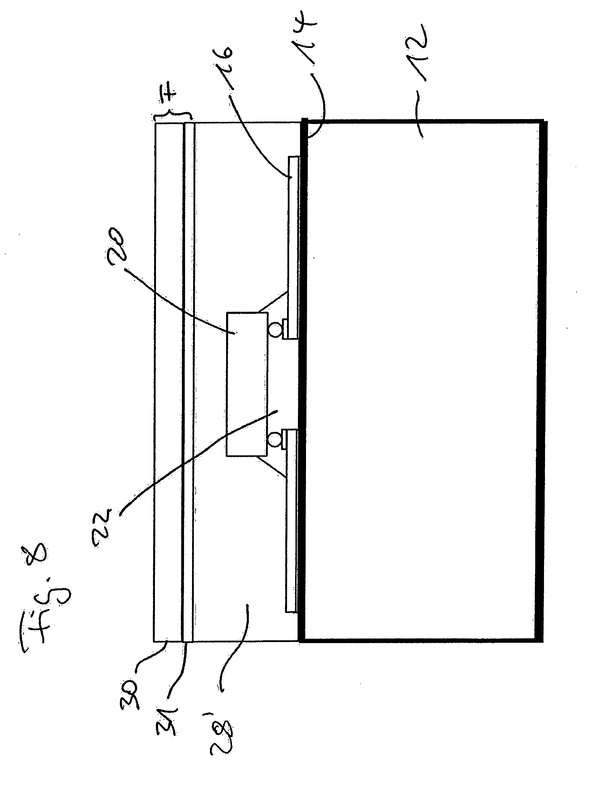

Figur 8 zeigt den Mehrschichtaufbau nach dem Verpressen mit in einer Harzschicht 28' formschlüssig eingebettetem Bauelement 20; die Harzschicht 28` ist aus den sich bei der Verpressung verflüssigenden und anschließend wieder erhärtenden Prepreg-Schichten 24, 28 entstanden. Die Kupferfolie F umfasst in der dargestellten Ausführungsform eine etwas dickere Trägerfolie 30 (mit einer Dicke von in der Größenordnung 70 µm), auf der, bspw. getrennt durch eine dünne Chromschicht, eine dünnere Basiskupferfolie 31 aufgebracht ist (die dünnere Folie weist eine Dicke von in der Größenordnung 7 µm auf). Die Kupferfolie F ist mit der dünneren Basiskupferfolie 31 zur Harzschicht 28' hin weisend aufgebracht.

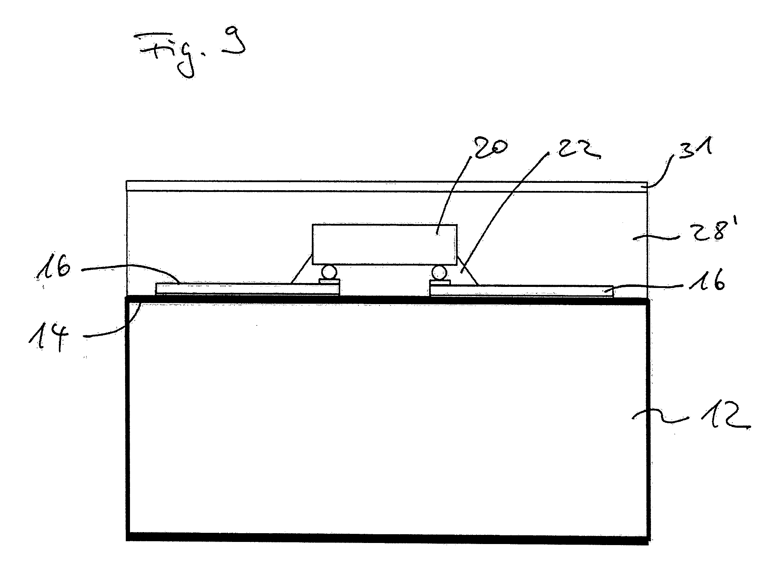

In einem nächsten Schritt wird die Trägerfolie 30 (sofern vorhanden) abgezogen (vgl. Figur 9), was sich aufgrund des starren Unterbaus des Trägers 12 ebenfalls als sehr unproblematisch erweist - sonst wäre es nur schwer möglich, von einer dünnen Schicht eine Trägerfolie ohne weiteres abzuziehen. Nach dem Abziehen der Trägerfolie 30 verbleibt die deutlich dünnere Basiskupferfolie 31 auf dem Mehrschichtaufbau. Vor einem Ablösen des starren Trägers 12 eröffnen sich nun weitere Bearbeitungsmöglichkeiten des erfindungsgemäßen Mehrschichtaufbaus.

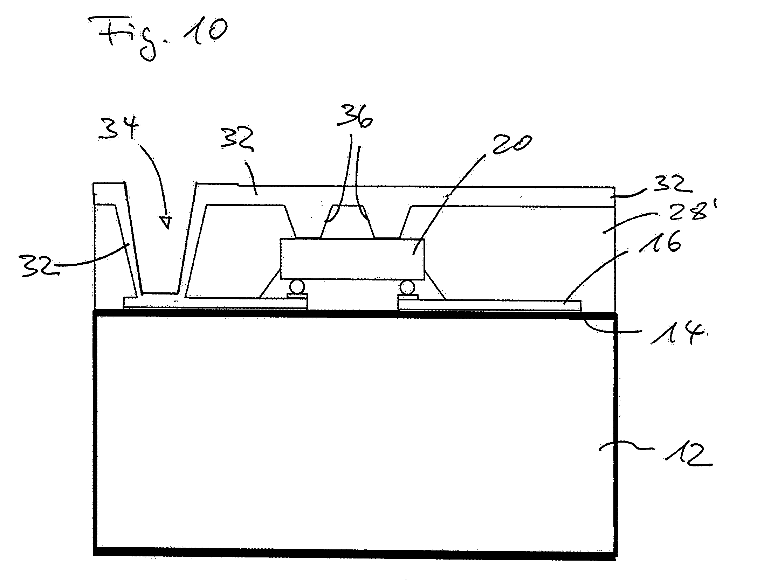

Figur 10 zeigt bspw. die Möglichkeit der Herstellung eines Sackloches 36 auf die Oberfläche des Bauelements 20 und/oder eines Sackloches 34 auf die Ebene der Leiterbildstruktur 16 zu Zwecken der Ankontaktierung. Hierfür sollte der Chip bzw. das Bauelement 20 über eine galvanikverträgliche Oberfläche verfügen. Das Bohren kann bspw. durch Laserbohren erfolgen, mit einem anschließenden Plattieren zur Herstellung einer durchgehenden Kupferschicht 32 (die Kupferschicht 32 besteht aus der auflaminierten Basiskupferfolie 31 plus darauf galvanisch abgeschiedenem Kupfer). In dem dargestellten Ausführungsbeispiel sind die Sacklöcher 36 zur Ankontaktierung des Bauelements 20 vollständig mit Kupfer gefüllt, während das Sackloch 34 zur Ankontaktierung der Leiterbahnen eine Kupferbeschichtung der Wandungen mit Kupfer aufweist.

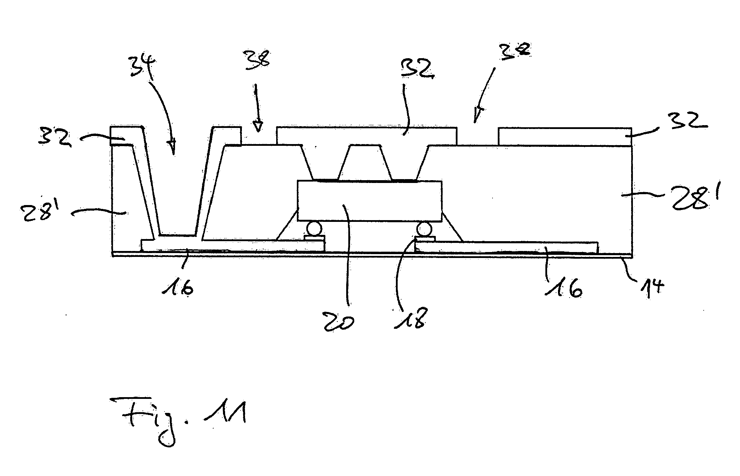

In einem nächsten Schritt (vgl. Figur 11) wird der starre Träger 12 entfernt. Dies erfolgt durch ein Auflösen bzw. Ätzen des starren Trägers 12 in einem geeigneten Medium; bei Aluminium wäre dies bspw. Natronlauge. Ggf. wird vor dem Ablösen des starren Trägers 12 ein Ätzschritt zum Ätzen des "Basiskupfers", also der Kupferplattierung 14 des Trägers 12 auf der (in der Darstellung der Figur) Unterseite des Trägers, durchgeführt, daraufhin ein selektives Ätzen des starren Trägers 12 und schließlich ein Entfernen der Kupferbeschichtung 14 an der Unterseite des Mehrschichtaufbaus, bspw. durch Differenzätzen, und dadurch Freilegung der Leiterbildstruktur 16. In diesem Zuge können auch einzelne Stellen der Kupferschicht 32 (vgl. Bezugszeichen 38) sowie der Kupferschicht 14 (nicht dargestellt) selektiv geätzt werden.

Unter "Differenzätzen" ist hierbei ein Ätzprozess zu verstehen, bei dem ein Ätzmedium das Kupfer (hier: Kupferbeschichtung 14) auflöst, dabei jedoch die darunterliegende Struktur (hier: Leiterbildstruktur 16) nicht oder nur geringfügig abträgt. Dies erfordert eine genaue Kontrolle der Ätztiefe und gestattet ein Abtragen der oberen Schicht ohne Verwendung von Ätzresist. Wird z.B. bei einer Schichtdicke der zu entfernenden (oberen) Schicht (Kupferbeschichtung 14) von ca. 5 µm durch Differenzätzen ca. 7 µm in die Tiefe geätzt, dann wird die obere Schicht vollständig entfernt, während die darunterliegende Schicht (der Leiterbildstruktur) nur um ca. 2 µm in ihrer Dicke reduziert wird.

Die entstandenen Aufbauten ("Packages") können auch nach dem Entfernen des starren Trägers 12 noch verarbeitet werden, bspw. durch Erzeugen von Durchkontaktierungen 40 mittels Bohren (Laser, mechanisch, Plasma) und anschließendes Aufplattieren von Kupfer.

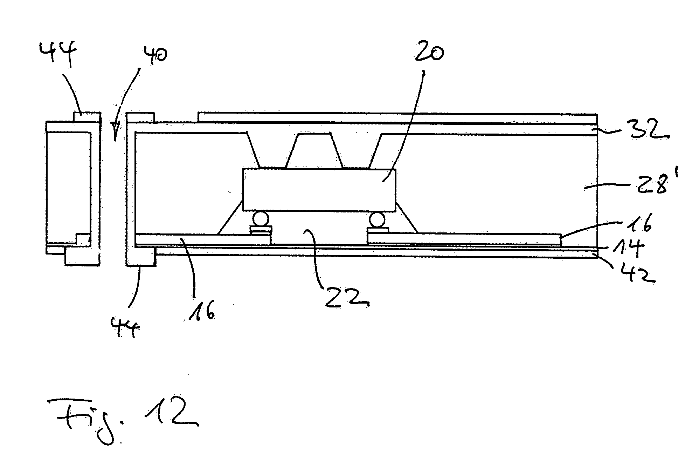

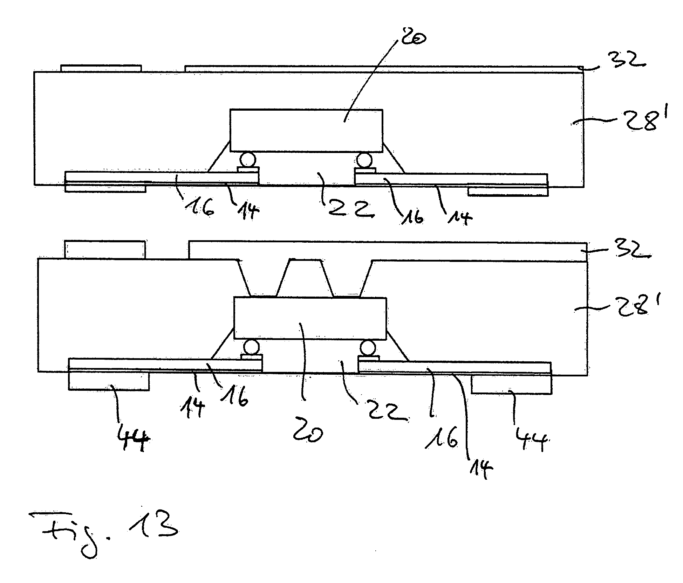

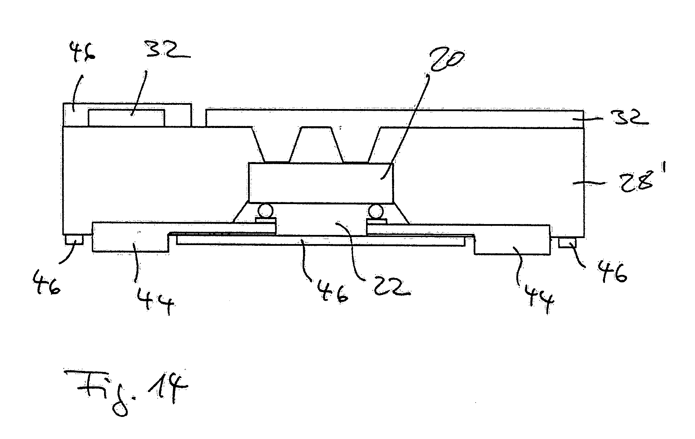

Gemäß der Erfindung sind die Leiterbildstrukturen 16 nach Entfernen der Kupferbeschichtung 14 in die Harzschicht 28` eingebettet, d.h. sie stehen nicht vor. Dies eröffnet die Möglichkeit, auf diesen "versunkenen" Leiterbildstrukturen eine zusätzliche Kupferschicht 42 durchgehend oder selektiv aufzubringen und an gewünschten Stellen stufige Leiter 44 auszubilden (vgl. Figuren 12 und 13). Das Aufplattieren der Schicht 42 erfolgt dabei vor dem Entfernen und/oder einem eventuellen Differenzätzen der Kupferbeschichtung 14. Offenliegende Leiter können durch Lötstopplack 46 geschützt werden (vgl. Figur 14). Durch das zumindest teilweise Entfernen der Kupferbeschichtung 14 (und der ggf. darauf plattierten Kupferschicht 42) wird die Leiterbildstruktur 16 "freigelegt", d.h. die Struktur des Leiterbilds mit der Schichtfolge 16 - 14 - 42 wird wieder sichtbar, indem die dazwischenliegenden und mit Kupfer (Kupferbeschichtung 14 und ggf. Kupferschicht 42) versehenen Bereiche geätzt werden. Je nachdem, welche Schichtdicke der Leiterstrukturen gefordert ist, kann auch zumindest teilweise die Beschichtung (14; 42) auf der eigentlichen Leiterbildschicht 16 (an)geätzt werden und/oder es können noch weitere Aufplattierungen vorgenommen werden (bspw. im Falle der beschriebenen stufigen Leiter 44).

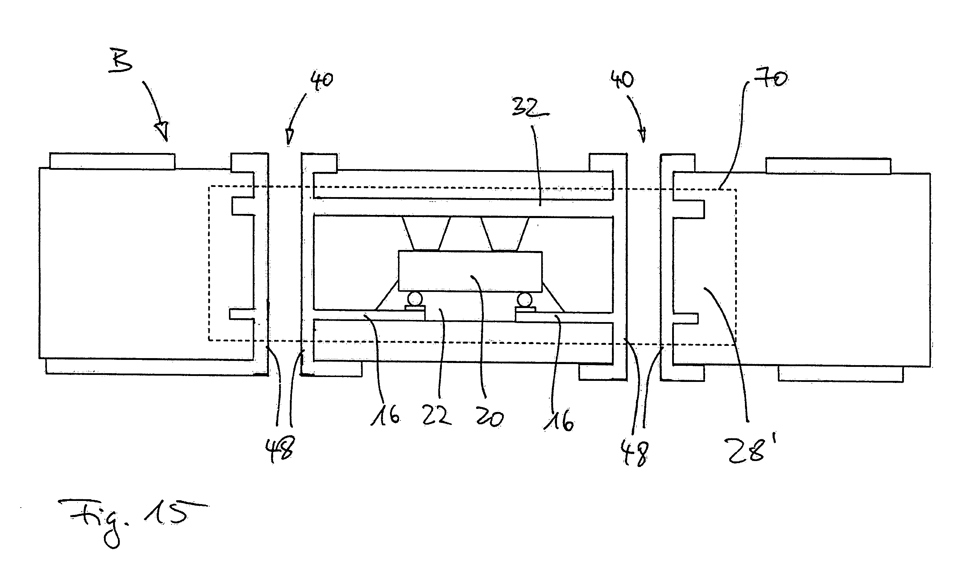

Figur 15 zeigt einen weiteren Einsatzbereich der Erfindung. Hierbei wird ein erfindungsgemäß vorgefertigtes Bauteil 70 (gestrichelt dargestellt) in einen Mehrschichtaufbau einer Leiterplatte B einlaminiert. Der elektrische Anschluss zu der Leiterplatte B erfolgt mittels Durchbohren der Leiterbildstruktur 16 an dafür vorgesehenen Positionen und Metallisieren dieser Bohrungen mit in der Leiterplattentechnik üblichen Prozessen (Kupferschicht 48). Um eine zuverlässige metallische Anbindung der Durchkontaktierungen 40 an die Leiterbildstruktur 16 zu gewährleisten, ist es vorteilhaft, diese aus reinem Kupfer auszuführen. Die aus der RU 2291598 C2 bekannte Schichtabfolge ist für einen derartigen Prozess ungeeignet.

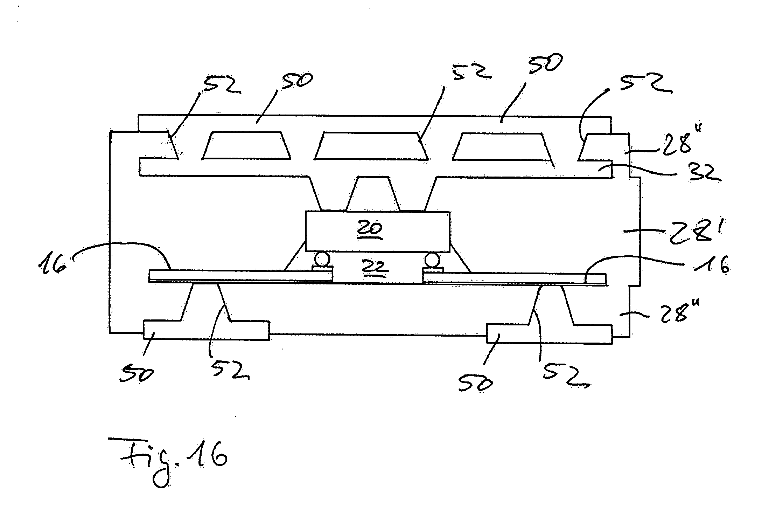

Figur 16 zeigt ein weiteres Ausführungsbeispiel, bei dem zusätzliche Lagen (bspw. FR-4- oder RCC-Lagen 28") auflaminiert werden und entsprechende zusätzliche Ebenen von Leiterbahnen 50 mit entsprechenden Durchkontaktierungen 52 ausgebildet werden können. Dadurch kann die Zuverlässigkeit der Aufbauten bei Temperatur-Wechselbeanspruchung erhöht werden.

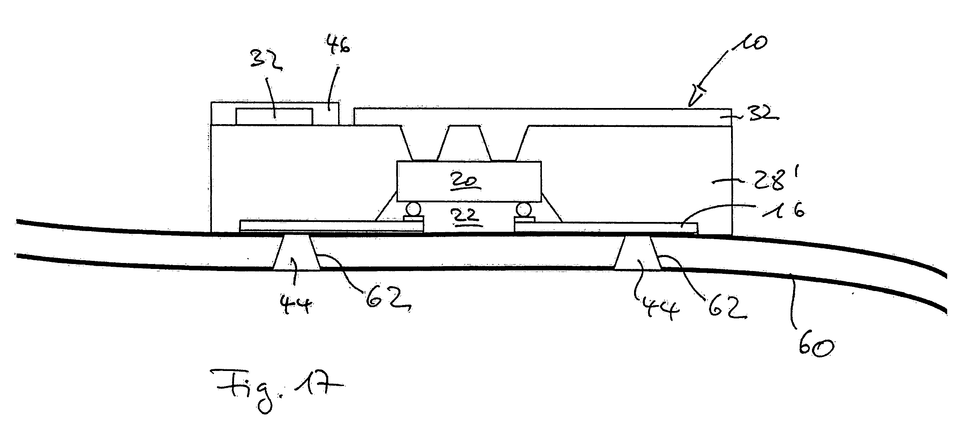

Figur 17 zeigt ein erfindungsgemäßes ultradünnes Package 10 auf einem sogenannten biegsamen Flex-Substrat 60. Der elektrische Kontakt zwischen flexibler Trägerleiterplatte und Leiterbildstruktur 16 des dünnen Bauelements erfolgt dabei über metallisierte Löcher 62, die z.B. mittels Laserabtrag erzeugt und über übliche Metallisierungsprozesse verkupfert werden. Dazu wird das ultradünne Package 10 mit dem Flex-Substrat 60 haftlaminiert, die Löcher 62 werden erzeugt und anschließend metallisiert. Die elektrische Anbindung zwischem dem Leiterstrukturelement 10 und dem Felx-Substrat 60 erfolgt somit über die Metallisierung der Löcher 62. Diese Löcher 62 können (wie in der Figur dargestellt) als auf die Leiterbahn 16 reichende Sacklöcher ausgebildet sein. Sie können jedoch auch als Durchgangslöcher ausgebildet sein (nicht dargestellt). Dadurch entsteht erfindungsgemäß eine dünne elektronische Baugruppe, die nicht gelötet werden muss.

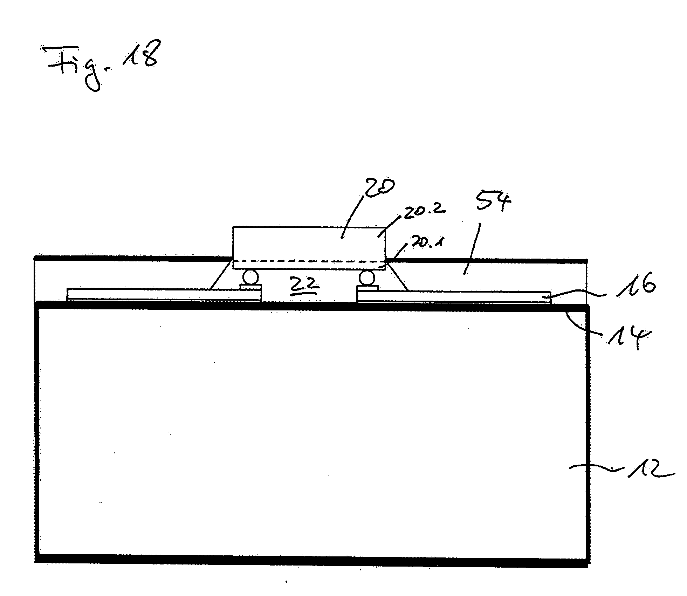

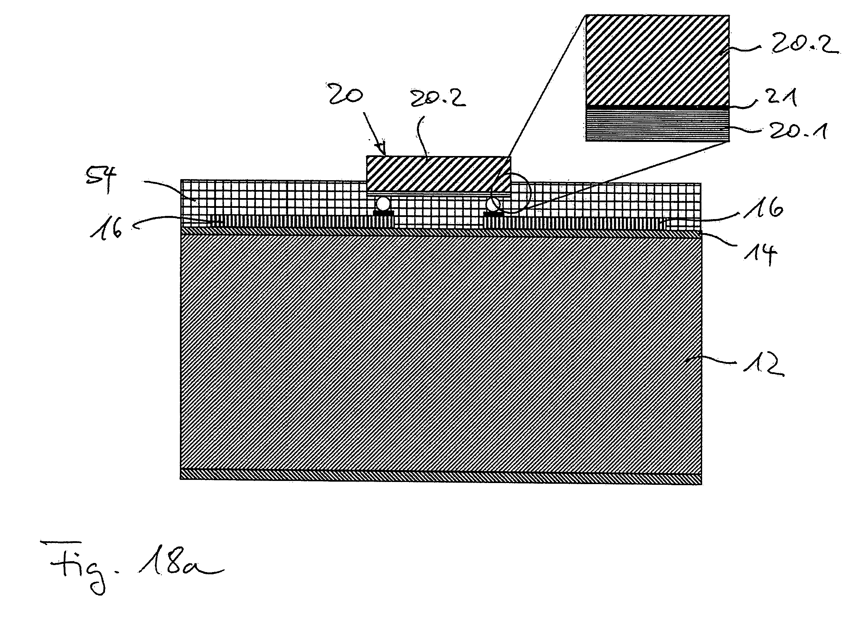

Figur 18 zeigt ein weiteres Ausführungsbeispiel eines erfindungsgemäßen Mehrschichtaufbaus vor dem Entfernen des starren Trägers 12. Gegenüber der bisher beschriebenen Variante ist bei dem in Figur 18 dargestellten Mehrschichtaufbau eine Schicht mit Ätzresist 54 aufgebracht. Die Ätzresist-Schicht 54 weist eine Höhe auf, die so gewählt ist, dass sie (in der Darstellung der Figur) unten liegende aktive Schichten 20.1 des Chips 20 umlaufend an dessen gesägten Kanten bedeckt, und zwar in der Höhe des Lagenübergangsbereiches. Damit ist die Stelle des Chips 20 gemeint, an der aktive und inaktive Lagen aufeinander treffen (in der Darstellung der Figur 18 als gestrichelte Linie dargestellt). Die Ätzresist-Schicht 54 wird also so dick aufgebracht, dass sie zumindest bis zu der Höhe dieser Stelle den Chip seitlich bedeckt. Sie kann jedoch auch dicker aufgetragen werden und somit den Chip höher als den Lagenübergangsbereich seitlich bedecken.

Als Ätzresist können Materialien verwendet werden, die temporär für den Ätzprozess verwendet werden und danach wieder entfernt werden, oder es werden Materialien verwendet, die ätzbeständig sind und aufgrund Ihrer Materialeigenschaften im Aufbau verbleiben können.

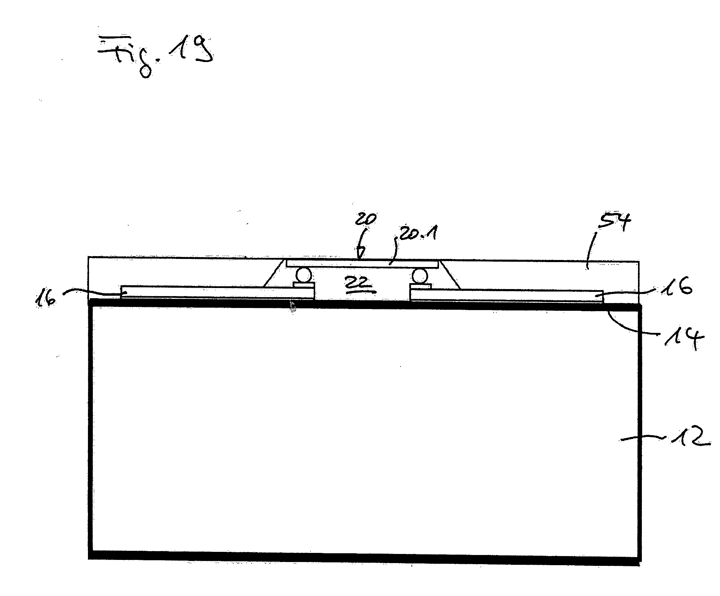

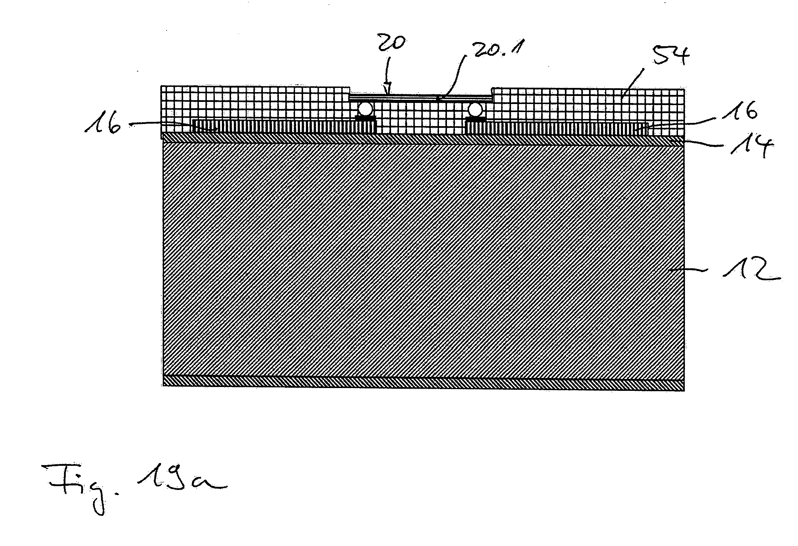

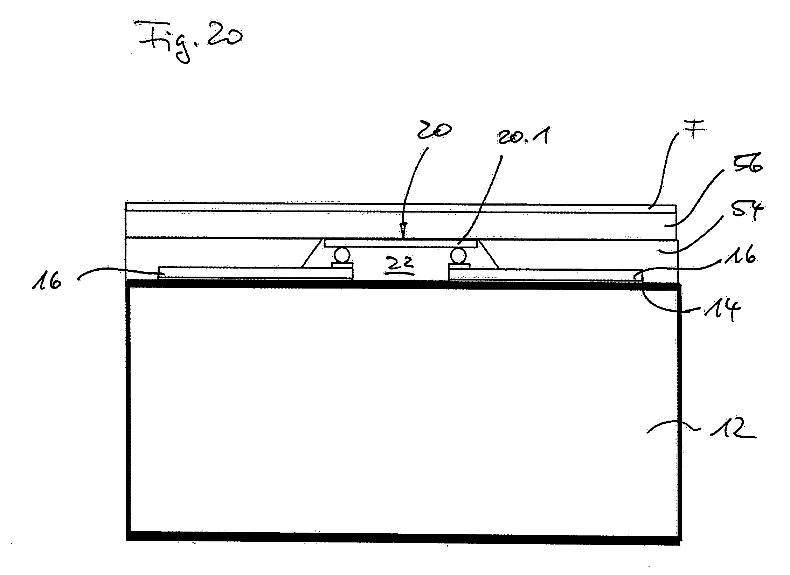

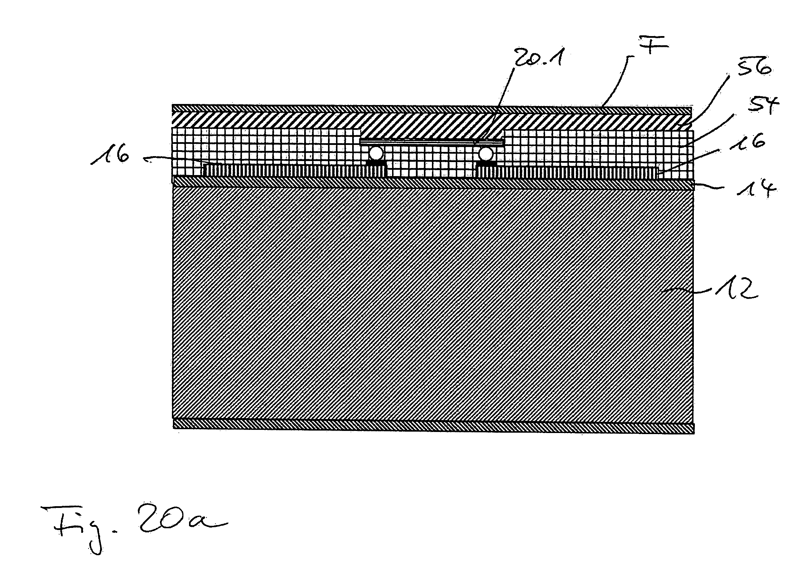

In einem nächsten Schritt werden (in der Darstellung der Figur 18) über den aktiven Schichten 20.1 liegende obere, nicht-aktive und über das Ätzresist 54 hinausragende Schichten 20.2 des Chips 20 abgetragen. Dies kann mechanisch und/oder chemisch erfolgen. Übrig bleiben lediglich die unteren aktiven Schichten 20.1 des Chips 20, ggf. ein dünner Rest der nicht-aktiven Schichten 20.2, so dass ein ultradünner Chip verbleibt, der nur die wesentlichen und notwendigen Schichten aufweist (vgl. Figur 19). Durch das erfindungsgemäße Verfahren kann die Bestückung von ultradünnen Chips erheblich vereinfacht werden, da diese sich bei einem Abdünnen im unbestückten Zustand, d.h. vor dem Bestücken, so stark verwölben, dass ein Bestückungsprozess nur mit erheblichem Aufwand gelingt. Die Anwesenheit einer Ätzresist-Schicht 54 legt natürlich ein chemisches Abtragen der inaktiven Chip-Schichten 20.2 nahe. Dies erfolgt mittels Ätzen. Zwischen den aktiven Schichten 20.1 und den nicht-aktiven (Silicium-)Schichten 20.2 des Chips 20 ist eine Schicht 21 aus ätzresistentem Material vorgesehen (die im Prinzip der gestrichelten Linie in der Darstellung der Figur 18 entspricht und im Prinzip den voranstehend beschriebenen Lagenübergangsbereich darstellt), wodurch der Ätzvorgang erleichtert wird, da er automatisch nach Erreichen der ätzresistenten Schicht 21 endet. Der somit bis auf seine aktiven Schichten 20.1 abgetragene Chip 20 schließt somit bündig mit der Oberfläche der Ätzresist-Schicht 54 ab oder liegt ggf. sogar etwas tiefer als diese, wenn die Ätzresist-Schicht 54 wie voranstehend erläutert höher als die aktiven Schichten 20.1 des Chips 20 aufgetragen wurde (vgl. Figur 18a). Die Ätzresist-Schicht 54 kann - wie in der Figur 18a sowie auch in den Figuren 19a und 20a dargestellt - alternativ zum Unterfüllen des Chips oder in Kombination mit einer separat ausgeführten Unterfüllung (Bezugszeichen 22 in den Figuren 18, 19 und 20) verwendet werden.

Nach dem Abtragen der nicht-aktiven Schichten 20.2 des Chips 20 (Figur 19) kann der entstandene Aufbau wie aus der Figur 20 ersichtlich mit einer Prepreg-Schicht 56 bedeckt und verpresst/laminiert werden. Ggf. kann eine darauf aufgebrachte Kupferfolie F mitverpresst werden. In den Figuren 19a und 20a ist jeweils die Ausführungsform mit dem chemisch rückgedünnten Chip 20 in vertiefter Lage gegenüber dem Niveau der Ätzresist-Schicht 54 dargestellt.

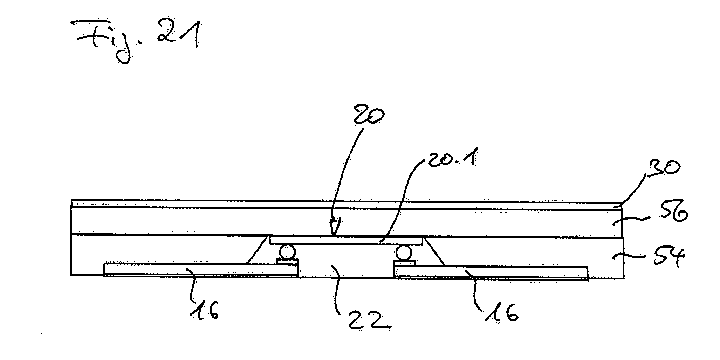

In einem nächsten Schritt (vgl. Figur 21) erfolgt das Ablösen des starren Trägers 12 sowie ein Differenzätzen der Kupferbeschichtung 14 sowie ggf. ein Weiterverarbeiten (wie auch bereits voranstehend in Zusammenhang mit den Figuren 11 bis 17 beschrieben, also bspw. Vorsehen von An- und/oder Durchkontaktierungen, Einlaminieren in einer Multilayerschicht, Verwendung als Interposer, usw.)

Die in Figur 20 dargestellte Struktur kann alternativ vor dem Ablösen des starren Trägers auch in einen Multilayeraufbau eingebracht werden, oder sie kann mit einem weiteren erfindungsgemäßen Mehrschichtaufbau mit einem starren Träger in Sandwichstruktur verpresst werden, so dass die beiden starren Träger jeweils außen (in der Darstellung der Figur unten und oben) zu liegen kommen und abschließend in einem gemeinsamen Ätzprozess aufgelöst bzw. abgelöst werden können. Vor dem Ablöseprozess können noch weitere Maßnahmen der Weiterverarbeitung vorgenommen werden.

Alternativ kann zunächst ein Ablösen des starren Trägers 12 erfolgen und daraufhin ein Einlaminieren in eine Leiterplatte. Da der abgetragene Chip 20 nunmehr bündig mit der Oberfläche des Ätzresists 54 abschließt, ggf. sogar etwas tiefer liegt, kann auf die Ausbildung von Kavitäten in Prepregs eines Multilayers verzichtet werden.

Durch die erfindungsgemäße Rückdünnung kann die Chipdicke bzw. -höhe sich auf die aktiven Lagen 20.1 beschränken und ist daher sehr dünn, je nach Chipdesign um ca. 10 µm. Damit kann eine Gesamtdicke des in Figur 21 dargestellten Mehrschichtaufbaus von ca. 100 µm erzielt werden.

Das Ablösen des nicht-aktiven Siliciums (Lagen 20.2) von der Rückseite des Chips 20 könnte auch durch eine veränderte Herstellung des Chips 20 selbst erleichtert werden: Vor der Herstellung der ersten aktiven Schichten 20.1 wird auf einem Wafer eine ätzbeständige Schicht abgeschieden. Auf dieser ätzbeständigen Schicht können nachfolgend Epitaxie-Schichten abgeschieden werden, aus denen sukzessive die aktiven Lagen 20.1 des Chips 20 entstehen. Der Wafer dient dabei als Träger für die aktiven Schichten 20.1.

Nach der Bestückung eines derart hergestellten Chips auf den erfindungsgemäßen Träger (und Vorbereitung wie in Zusammenhang mit Figur 15 beschrieben) könnte nun mit einem Ätzmedium das Trägersilizium vollständig abgeätzt werden.

## Patentansprüche

1. Verfahren zum Herstellen eines Leiterstrukturelements, mit folgenden Schritten:
- Bereitstellen eines starren Trägers (12),
- Galvanisches Abscheiden einer Kupferbeschichtung (14) auf dem starren Träger (12),
- Aufbringen einer Leiterbildstruktur (16) auf die Kupferbeschichtung (14),
- Laminieren des Trägers mit mindestens einer elektrisch isolierenden Lage (24, 28),
- Ablösen des starren Trägers (12),
- zumindest teilweises Entfernen der verbliebenen Kupferbeschichtung (14) des starren Trägers (12), derart dass eine Freilegung der Leiterbildstruktur (16, 14, 42) erfolgt.

2. Verfahren nach Anspruch 1, wobei die Kupferbeschichtung (14) des starren Trägers (12) eine Dicke zwischen ca. 2 und ca. 7 µm aufweist.

3. Verfahren nach Anspruch 1 oder 2, bei dem die flächige Kupferbeschichtung (14) erst nach Abscheiden eines weiteren, äußeren Leiterbilds (42, 44) darauf entfernt wird.

4. Verfahren nach einem der Ansprüche 1 bis 3, mit dem Schritt des Abscheidens einer ätzbeständigen Metalllage unter der Leiterbildstruktur (16) vor deren Aufbringen.

5. Verfahren nach einem der Ansprüche 1 bis 4, bei dem der Schritt des Aufbringens einer Leiterbildstruktur (16) das Aufbringen einer ersten Plattierung und das nachfolgende zumindest bereichsweise Aufplattieren auf der ersten Plattierung zum Erzielen unterschiedlicher Kupferschichtdicken in einer Lage umfasst.

6. Verfahren nach einem der Ansprüche 1 bis 5, bei dem vor dem Schritt des Ablösens des starren Trägers (12) noch folgende Schritte vorgesehen sind:
- Verlegen mindestens einer Klebelage (24, 28) auf dem Mehrschichtaufbau und
- Verpressen mit einer Kupferfolie (F) als Abschlusslage zur Laminatbildung und/oder Verpressen mit einem aus einer Abfolge mehrerer leitender und isolierender Lagen bestehenden Leiterplatten-Halberzeugnis.

7. Verfahren nach einem der voranstehenden Ansprüche, bei dem der Schritt des Aufbringens einer Leiterbildstruktur (16) auf die Kupferbeschichtung (14) gefolgt wird von einer Bauelementbestückung.

8. Verfahren nach Anspruch 7, mit dem Schritt des Unterfüllens (22) von mindestens einem der bestückten Bauelemente (20).

9. Verfahren nach einem der Ansprüche 1 bis 8, das den Schritt des Rückdünnens bzw. Abtragens eines bestückten Chips (20) umfasst.

10. Verfahren nach Anspruch 9, bei dem der Schritt des Rückdünnens das Aufbringen einer ätzresistenten Schicht (54) zur seitlichen Abdeckung aktiver Chiplagen (20.1) an den Chipkanten und das anschließende Entfernen überstehender, nicht-aktiver Chiplagen (20.2) umfasst.

11. Verfahren nach einem der Ansprüche 9 oder 10, bei dem die aktiven Lagen (20.1) des Chips (20) auf einer ätzbeständigen Schicht (21) hergestellt wurden, die die aktiven Lagen des Chips beim Prozess des Rückdünnens vor Ätzangriff schützt.

12. Leiterstrukturelement, mit einem in eine Dielektrikum-Schicht (28') eingebrachten Bauelement (20), das mit einer Leiterbildstruktur (16) verbunden ist, die im wesentlichen bündig mit einer Oberfläche der Dielektrikum-Schicht (28`) abschließt, **dadurch gekennzeichnet, dass** die Leiterbildstruktur (16) ausschließlich aus aufplattiertem Kupfer besteht, auf der eine galvanisch abgeschiedene Kupferbeschichtung (14) vorgesehen ist, und wobei auf der der einen Oberfläche gegenüberliegenden Seite des Leiterstrukturelements eine durchgehende Kupferschicht (32) vorgesehen ist.

13. Leiterstrukturelement nach Anspruch 12, bei dem die durchgehende Kupferschicht (32) an einzelnen Stellen selektiv geätzt ist.

14. Leiterstrukturelement nach Anspruch 12 oder 13, bei dem eine aufplattierte zusätzliche Kupferschicht (42) vorgesehen ist, die gemeinsam mit der galvanisch abgeschiedenen Kupferbeschichtung (14) differenzgeätzt ist.

15. Leiterstrukturelement nach Anspruch 12 oder 13 oder 14, bei dem die durchgehende Kupferschicht (32) aus einer auflaminierten Basiskupferfolie (31) besteht oder aus einer auflaminierten Basiskupferfolie (31) und auf dieser galvanisch abgeschiedenem Kupfer besteht.

16. Leiterstrukturelement nach einem der Ansprüche 12 bis 15, bei dem zwischen der Leiterbildstruktur (16) und der Kupferbeschichtung (14) eine ätzbeständige Metalllage vorgesehen ist.

17. Leiterstrukturelement nach einem der Ansprüche 12 bis 16, mit von der versunkenen Leiterbildstruktur (16) abragenden aufplattierten Leitern (44).

18. Elektronische Baugruppe mit einem Flex-Substrat (62) und mit einem Leiterstrukturelement (10) gemäß einem der Ansprüche 12 bis 17, das lötfrei mittels metallisierten Löchern (62) an das Flex-Substrat (60) elektrisch angebunden ist.

## Claims

1. A method for producing a conductor structure element comprising the following steps of:
- providing a rigid support (12);
- electroplating a copper coating (14) onto the rigid support (12);
- applying a conductor pattern structure (16) onto the copper coating (14);
- laminating the support with at least one electrically insulating layer (24, 28);
- detaching the rigid support (12);
- at least partially removing the remaining copper coating (14) of the rigid support (12) such that an exposure of the conductor pattern structure (16, 14, 42) is effected.

2. The method according to claim 1, wherein the copper coating (14) of the rigid support (12) has a thickness between about 2 and about 7 µm.

3. The method according to claim 1 or 2, in which the planar copper coating (14) is only removed after a further external conductor pattern (42, 44) is deposited thereon.

4. The method according to any one of claims 1 to 3, including the step of depositing an etch-resistant metal layer below the conductor pattern structure (16) before application thereof.

5. The method according to any one of claims 1 to 4, in which the step of applying a conductor pattern structure (16) includes the application of a first plating and the subsequent plating onto the first plating at least in certain areas in order to achieve different copper layer thicknesses in a ply.

6. The method according to any one of claims 1 to 5, in which before the step of detaching the rigid support (12), the following steps are also provided:
- laying at least one adhesive ply (24, 28) on the multi-layer structure; and
- pressing with a copper foil (F) as a final ply for laminate formation and/or pressing with a semi-finished circuit board product composed of a succession of several conducting and insulating plies.

7. The method according to any one of the preceding claims, in which the step of applying a conductor pattern structure (16) onto the copper coating (14) is followed by component mounting.

8. The method according to claim 7 including the step of underfilling (22) at least one of the mounted components (20).

9. The method according to any one of claims 1 to 8, which includes the step of back-thinning or ablating a mounted chip (20).

10. The method according to claim 9, in which the step of back-thinning includes the application of an etch-resistant layer (54) for laterally covering active chip plies (20.1) at the chip edges and the subsequent removal of protruding, non-active chip plies (20.2).

11. The method according to any one of claims 9 or 10, in which the active plies (20.1) of the chip (20) have been produced on an etch-resistant layer (21) which protects the active plies of the chip from an etch attack in the process of back-thinning.

12. A conductor structure element, comprising a component (20) incorporated in a dielectric layer (28'), the component being connected to a conductor pattern structure (16) which is substantially flush with a surface of the dielectric layer (28'), **characterized in that** the conductor pattern structure (16) is exclusively composed of plated copper, on which an electroplated copper coating (14) is provided, and wherein a continuous copper layer (32) is provided on the side of the conductor structure element opposing the one surface.

13. The conductor structure element according to claim 12, in which the continuous copper layer (32) is selectively etched at individual locations.

14. The conductor structure element according to claim 12 or 13, in which a plated additional copper layer (42) is provided, which is differentially etched together with the electroplated copper coating (14).

15. The conductor structure element according to claim 12 or 13 or 14, in which the continuous copper layer (32) is composed of a laminated base copper foil (31) or is composed of a laminated base copper foil (31) and copper electroplated on it.

16. The conductor structure element according to any one of claims 12 to 15, in which an etch-resistant metal ply is provided between the conductor pattern structure (16) and the copper coating (14).

17. The conductor structure element according to any one of claims 12 to 16, further comprising plated conductors (44) protruding from the buried conductor pattern structure (16).

18. An electronic assembly comprising a flex substrate (62) and comprising a conductor structure element (10) according to any one of claims 12 to 17, the conductor structure element being electrically connected to the flex substrate (60) in a solderless manner by means of metallized holes (62).

## Revendications

1. Procédé pour la fabrication d'un élément à structure conductrice, comprenant les étapes suivantes :
- on prépare un support rigide (12),
- on dépose par voie galvanique un revêtement de cuivre (14) sur le support rigide (12),
- on applique une structure de motif conducteur (16) sur le revêtement de cuivre (14),
- on stratifié le support avec au moins une couche électriquement isolante (24, 28),
- on détache le support rigide (12),
- on enlève au moins partiellement le revêtement de cuivre restant (14) du support rigide (12), de telle manière qu'il se produit un dénudage de la structure de motif conducteur (16, 14, 42).

2. Procédé selon la revendication 1, dans lequel le revêtement de cuivre (14) du support rigide (12) présente une épaisseur entre environ 2 et environ 7 µm.

3. Procédé selon la revendication 1 ou 2, dans lequel le revêtement de cuivre surfacique (14) est enlevé uniquement après déposition d'un autre motif conducteur extérieur (42, 44) sur celui-ci.

4. Procédé selon l'une des revendications 1 à 3, comprenant l'étape consistant à déposer une couche de métal résistant aux attaques chimiques au-dessous de la structure à motif conducteur (16) avant son application.

5. Procédé selon l'une des revendications 1 à 4, dans lequel l'étape consistant à appliquer une structure de motif conducteur (16) inclut les opérations consistant à appliquer un premier plaquage et à la suite au moins localement un nouveau plaquage sur le premier plaquage pour atteindre des épaisseurs différentes de la couche de cuivre dans une strate.

6. Procédé selon l'une des revendications 1 à 5, dans lequel, avant l'étape consistant à détacher le support rigide (12) on prévoit encore les opérations suivantes :
- on pose au moins une couche de colle (24, 28) sur la structure multicouche, et
- on applique à la presse une feuille de cuivre (F) à titre de couche finale pour la formation du stratifié et/ou on applique à la presse avec un produit semi-fini de plaque conductrice constitué d'une succession de plusieurs couches conductrices et isolantes.

7. Procédé selon l'une des revendications précédentes, dans lequel l'opération consistant à appliquer une structure de motif conducteur (16) sur le revêtement de cuivre (14) est suivie par le montage de composants structurels.

8. Procédé selon la revendication 7, comprenant l'opération consistant à charger (22) par le dessous l'un au moins des composants montés (20).

9. Procédé selon l'une des revendications 1 à 8, qui inclut l'opération consistant à amincir ou à enlever une puce montée (20).

10. Procédé selon la revendication 9, dans lequel l'étape d'amincissement inclut l'application d'une couche résistante aux attaques chimiques (54) pour le recouvrement latéral de couches de puces actives (20.1) au niveau des arêtes des puces, et l'enlèvement successif de couches de puces non actives en dépassement (20.2).

11. Procédé selon l'une des revendications 9 ou 10, dans lequel les couches actives (20.1) de la puce (20) ont été réalisées sur une couche résistante aux attaques chimiques (21), qui protège les couches actives de la puce vis-à-vis d'une attaque chimique lors du processus d'amincissement.

12. Élément à structure conductrice, comprenant un élément structurel (20) intégré dans une couche diélectrique (28') et relié avec une structure de motif conducteur (16), qui se termine sensiblement en affleurement avec une surface de la couche diélectrique (28'), **caractérisé en ce que** la structure de motif conducteur (16) est exclusivement constituée de cuivre appliqué par plaquage, sur lequel est prévu un revêtement de cuivre déposé par voie galvanique (14), et dans lequel il est prévu une couche de cuivre continue (32) sur un côté, opposé à la première surface, de l'élément à structure conductrice.

13. Élément à structure conductrice selon la revendication 12, dans lequel la couche de cuivre continue (32) est attaqué chimiquement de manière sélective au niveau d'emplacements individuels.

14. Élément à structure conductrice selon la revendication 12 ou 13, dans lequel il est prévu une couche de cuivre additionnelle (42) appliquée par plaquage, qui subit une attaque chimique différentielle conjointement avec le revêtement de cuivre (14) déposé par voie galvanique.

15. Élément à structure conductrice selon la revendication 12 ou 13 ou 14, dans lequel la couche de cuivre continue (32) est constituée d'une feuille de cuivre de base (31) appliquée par stratification, ou d'une feuille de cuivre de base (31) appliquée par stratification et de cuivre déposé sur celle-ci par voie galvanique.

16. Élément à structure conductrice selon l'une des revendications 12 à 15, dans lequel il est prévu une couche de métal résistant aux attaques chimiques entre la structure de motif conducteur (16) et le revêtement de cuivre (14).

17. Élément à structure conductrice selon l'une des revendications 12 à 16, comprenant des conducteurs (44) appliqués par plaquage en dépassement de la structure de motif conducteur (16) noyée.

18. Groupe structurel électronique comprenant un substrat flexible (62) et un élément à structure conductrice (10) selon l'une des revendications 12 à 17, qui est joint sur le plan électrique sur le substrat flexible (60) sans soudure au moyen de trous métallisés (62).
